# EUROPEAN PATENT APPLICATION

(11) **EP 2 568 516 A1**
(43) Date of publication of application: **13.03.2013**
(21) Application number: 12177989.6
(22) Date of filing: 26.07.2012
(51) Int. Cl.: H01L 51/05, H01L 51/00, H01L 29/423

(54) **Thin-film transistor and electronic unit**

(30) Priority: 12.09.2011 JP 2011198457
(71) Applicant: Sony Corporation, Tokyo 108-0075 (JP)
(72) Inventor: Hirai, Nobukazu, Minato-ku Tokyo 108-0075 (JP)
(74) Representative: Meldrum, David James

(57) **Abstract**

A thin-film transistor includes: a gate electrode; a semiconductor layer separated from the gate electrode with a separation insulating layer in between; and a source electrode and a drain electrode that are connected with the semiconductor layer and are separated from each other. Between the source electrode and the drain electrode, a thickness of the separation insulating layer at a first region where the gate electrode does not overlap both the source electrode and the drain electrode is smaller than a thickness of the separation insulating layer at a second region where the gate electrode overlaps one or both of the source electrode and the drain electrode.

## Description

### BACKGROUND

The present technology relates to a thin-film transistor including a semiconductor layer, and an electronic unit using the same.

In recent years, a thin-film transistor (TFT) has been used as a switching device and the like for a variety of electronic units. As such a TFT, an inorganic TFT using an inorganic semiconductor material and an organic TFT using an organic semiconductor material for forming a semiconductor layer (channel layer) are known.

A TFT includes: a gate electrode; a semiconductor layer that is separated from the gate electrode with a gate insulating layer in between; and a source electrode and a drain electrode that are connected with the semiconductor layer and are separated from each other.

To achieve a high-performance TFT, it is necessary to assure insulation properties between the gate electrode and the source electrode, and between the gate electrode and the drain electrode. This is because the performance of a TFT deteriorates in the event that a leakage current flows between the gate electrode and the source electrode and between the gate electrode and the drain electrode.

Consequently, various considerations have been given to improve the insulation properties between the gate electrode and the source electrode and between the gate electrode and the drain electrode. In concrete terms, it is proposed to use an organic material having both of alkyl group and silane group as a substituent for a material for forming a gate insulating layer (for example, see Japanese Unexamined Patent Application Publication No. 2006-216938). Further, it is proposed to perform a surface modification for a gate insulating layer (for example, see Japanese Unexamined Patent Application Publication No. 2007-194360). In addition, to improve the compatibility between a material for forming a gate insulating layer and a material for forming a semiconductor layer, it is proposed to form a gate insulating layer using an atmospheric pressure plasma method (for example, see Japanese Unexamined Patent Application Publication No. 2004-103638).

### SUMMARY

In the past, methods of improving the insulation properties between the gate electrode and the source electrode and between the gate electrode and the drain electrode have been proposed, although there is still room for improvement in a viewpoint of the feasibility. This is because use of a new material for forming a gate insulating layer excludes use of any existing materials, which narrows a material selection range. For another reason, a surface modification for a gate insulating layer complicates a TFT manufacturing process, while causing an issue with the repeatability.

The present approach can provide a thin-film transistor and an electronic unit that allow the performance improvement to be easily achieved.

Particular aspects and embodiments are set forth in the appended independent and dependent claims.

According to an embodiment of the present disclosure, there is provided a thin-film transistor, including: a gate electrode; a semiconductor layer separated from the gate electrode with a separation insulating layer in between; and a source electrode and a drain electrode that are connected with the semiconductor layer and are separated from each other. Between the source electrode and the drain electrode, a thickness of the separation insulating layer at a first region where the gate electrode does not overlap both the source electrode and the drain electrode is smaller than a thickness of the separation insulating layer at a second region where the gate electrode overlaps one or both of the source electrode and the drain electrode.

Further, according to an embodiment of the present disclosure, there is provided an electronic unit with a thin-film transistor, the thin-film transistor including: a gate electrode; a semiconductor layer separated from the gate electrode with a separation insulating layer in between; and a source electrode and a drain electrode that are connected with the semiconductor layer and are separated from one another. Between the source electrode and the drain electrode, a thickness of the separation insulating layer at a first region where the gate electrode does not overlap both the source electrode and the drain electrode is smaller than a thickness of the separation insulating layer at a second region where the gate electrode overlaps one or both of the source electrode and the drain electrode.

In the thin-film transistor or the electronic unit according to the embodiment of the present disclosure, the semiconductor layer is separated from the gate electrode with the separation insulating layer in between, and a thickness of the separation insulating layer at the first region is smaller than a thickness of the separation insulating layer at the second region. This allows the performance improvement of the thin-film transistor and the electronic unit to be easily achieved.

It is to be understood that both the foregoing general description and the following detailed description are exemplary, and are intended to provide further explanation of the technology as claimed.

### BRIEF DESCRIPTION OF THE DRAWINGS

The accompanying drawings are included to provide a further understanding of the present disclosure, and are incorporated in and constitute a part of this specification. The drawings illustrate embodiments and, together with the specification, serve to explain the principles of the present technology.
FIGs. 1A and 1B are each a plan view and a sectional view showing a configuration of a thin-film transistor according to an embodiment of the present technology.
FIG. 2 is a sectional view showing a configuration of a thin-film transistor according to a first comparative example.
FIG. 3 is a sectional view showing a configuration of a thin-film transistor according to a second comparative example.
FIG. 4 is a sectional view showing a configuration of a first modification example for a thin-film transistor.
FIG. 5 is a sectional view showing a configuration of a second modification example for a thin-film transistor.
FIG. 6 is a sectional view showing a configuration of a third modification example for a thin-film transistor.
FIG. 7 is a sectional view showing a configuration of a fourth modification example for a thin-film transistor.
FIG. 8 is a sectional view showing a configuration of a fifth modification example for a thin-film transistor.
FIG. 9 is a sectional view showing a configuration of a liquid crystal display that is an application example of a thin-film transistor.
FIG. 10 is a circuit diagram of the liquid crystal display shown in FIG. 9.
FIG. 11 is a sectional view showing a configuration of an organic electroluminescence (EL) display that is an application example of a thin-film transistor.
FIG. 12 is a circuit diagram of the organic EL display shown in FIG. 11.
FIG. 13 is a sectional view showing a configuration of an electronic paper display that is an application example of a thin-film transistor.

### DETAILED DESCRIPTION

Hereinafter, embodiments of the present technology are described in details with reference to the drawings.

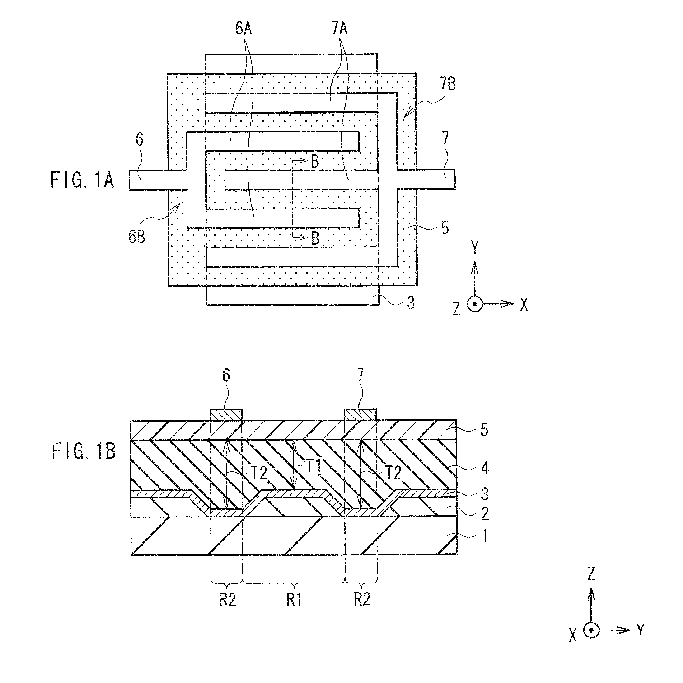

First, description is provided on a configuration of a thin-film transistor according to an embodiment of the present technology. FIG. 1A shows a planar configuration, while FIG. 1B shows a cross-sectional configuration of the thin-film transistor, and a cross-sectional surface illustrated in FIG. 1B is a cross-sectional surface along a B-B line illustrated in FIG. 1A. It is to be noted that FIG. 1A shows only a part of components of the thin-film transistor shown in FIG. 1B, and FIG. 1B is changed from FIG. 1A in a scale size to clarify a feature in configuration of the thin-film transistor.

The thin-film transistor described here is a TFT including a semiconductor layer 5 as a channel layer. This TFT includes on a support substrate 1, for example, a stepped insulating layer 2, a gate electrode 3, a gate insulating layer 4, the semiconductor layer 5, a source electrode 6, and a drain electrode 7.

In other words, the TFT shown in FIGs. 1A and 1B is of a bottom gate/top contact type, wherein the gate electrode 3 is arranged at the bottom side of the semiconductor layer 5, and the source electrode 6 and the drain electrode 7 are arranged at the top side of the semiconductor layer 5. It is to be noted that the "top side" is a side far away from the support substrate 1, while the "bottom side" is a side close to the support substrate 1.

Hereinafter, as shown in FIG. 1B, between the source electrode 6 and the drain electrode 7, a region where the gate electrode 3 and the source electrode 6 do not overlap each other, and a region where the gate electrode and the drain electrode 7 do not overlap each other are defined as "non-overlapping region R1 (first region)". Further, a region where the gate electrode 3 and the source electrode 6 overlap each other, and a region where the gate electrode 3 and the drain electrode 7 overlap each other are defined as "overlapping region R2 (second region)". The presence or absence of "overlapping" defined here means whether or not a region formed with the source electrode 6 and a region formed with the drain electrode 7 are overlapped with a region formed with the gate electrode 3 when the TFT is viewed from the upside (upper side of a space in FIG. 1A).

The support substrate 1 is formed of, for example, any one or more kinds of plastic materials, metallic materials, or inorganic materials.

Examples of plastic materials include polymethyl methacrylate (PMMA), polyvinyl alcohol (PVA), polyvinyl phenol (PVP), polyether sulfone (PES), polycarbonate (PC), polyimide (PI), polyethylene terephthalate (PET), polyethylene naphthalate (PEN), polyethyl ether ketone (PEEK), polyacrylate (PAR), polyphenylene sulfide (PPS), and triacetylcellulose (TAC). Examples of metallic materials include aluminum (AI), nickel (Ni), or stainless steel. Examples of inorganic materials include silicon (Si), silicon oxide (SiOx), silicon nitride (SiNx), aluminum oxide (AlOx), and other metal oxides. It is to be noted that silicon oxide includes glass, quartz, and spin on glass (SOG).

The support substrate 1 may be a substrate having the rigidity, such as a wafer, or may be a film or a foil having the flexibility. Alternatively, a variety of layers including a single layer or two or more layers that have prescribed functions may be provided on at least a part of the front surface of the support substrate 1. Examples of such a layer include a buffer layer to assure the adhesiveness, and a gas barrier layer to prevent gas emission.

It is to be noted that the support substrate 1 may be a single layer or have a multilayer structure. In the case of a multilayer structure, two or more layers that are formed of various materials as described above are laminated. Such a single layer or multilayer structure is also permitted for the stepped insulating layer 2, the gate electrode 3, the gate insulating layer 4, the semiconductor layer 5, the source electrode 6, the drain electrode 7, and other components to be hereinafter described.

The stepped insulating layer 2 is selectively formed on the support substrate 1, and more specifically is arranged at the non-overlapping region R1 at a minimum. However, the overlapping region R2 is excluded from a region formed with the stepped insulating layer 2. The stepped insulating layer 2 allows a distance between the gate electrode 3 and all of the semiconductor layer 5, the source electrode 6, and the drain electrode 7, namely, a thickness of a separation insulating layer which separates the semiconductor layer 5 and the like from the gate electrode 3 to be varied. This separation insulating layer is to be detailed hereinafter. Further, the stepped insulating layer 2 includes, for example, any one or more kinds of inorganic insulating materials or organic insulating materials. Examples of inorganic insulating materials include silicon oxide, silicon nitride, aluminum oxide, titanium oxide (TiO2), hafnium oxide (HfOx), and barium titanate (BaTi03). Examples of organic insulating materials include polyvinyl phenol (PVP), polyvinyl alcohol (PVA), polyimide, polyamide, polyester, polyacrylate, polyacrylate methacrylate, epoxy resin, benzocyclobutene (BCB), fluorocarbon resin, photosensitive polyimide, photosensitive novolac resin, and polyparaxylene.

It is to be noted that FIG. 1B shows a case where a cross-sectional surface of the stepped insulating layer 2 takes a trapezoidal form or an approximately trapezoidal form, although the cross-sectional surface thereof is not specifically limited to such a form, and any other shape (for example, a rectangular form) may be applicable.

The gate electrode 3 is formed to cover the stepped insulating layer 2 provided at the non-overlapping region R1, and the overlapping region R2 (support substrate 1). Therefore, the gate electrode 3 is located between the stepped insulating layer 2 and the gate insulating layer 4 at the non-overlapping region R1. The gate electrode 3 includes, for example, any one or more kinds of metallic materials, inorganic conductive materials, organic conductive materials, or carbon materials.

Examples of metallic materials include aluminum, copper (Cu), molybdenum (Mo), titanium (Ti), chromium (Cr), nickel, palladium (Pd), gold (Au), silver (Ag), platinum (Pt), tungsten (W), tantalum (Ta), and alloy containing any of these metal elements. Examples of inorganic conductive materials include indium oxide (In2O3), indium tin oxide (ITO), indium zinc oxide (IZO), and zinc oxide (ZnO). Examples of organic conductive materials include polyethylenedioxythiophene (PEDOT), polystyrene sulfonate (PSS), and polyaniline (PANI). Examples of carbon materials include graphite. It is to be noted that the gate electrode 3 may be, for example, multi-layered using materials such as PEDOT/PSS.

Being formed on the gate electrode 3, the gate insulating layer 4 is located between the gate electrode 3 and all of the semiconductor layer 5, the source electrode 6, and the drain electrode 7. The gate insulating layer 4 includes the same materials as for the stepped insulating layer 2 for example. It is preferable that the front surface (top surface) of the gate insulating layer 4 at a side close to the semiconductor layer 5 be as flat as possible. This is because the front surface flatness of the gate insulating layer 4 has an influence on the electrical characteristics of the semiconductor layer 5. More specifically, when the front surface of the gate insulating layer 4 is flat, the semiconductor layer 5 is also easily formed in a flat state on the gate insulating layer 4. This improves the alignment property of semiconductor molecules in the semiconductor layer 5, resulting in the electrical characteristics being stabilized.

Above all, for the gate insulating layer 4, it is preferable to contain an organic insulating material. This is because the gate insulating layer 4 is formed by applying a solution in which the organic insulating material is dispersed or dissolved in an organic solvent and the like, thereby making it easy to planarize the front surface of the gate insulating layer 4 by virtue of leveling (planarizing) action at the time of solution application.

The semiconductor layer 5, which is formed on the gate insulating layer 4, may be an inorganic semiconductor layer or an organic semiconductor layer.

An inorganic semiconductor layer includes, for example, any one or more kinds of inorganic semiconductor materials such as silicon. Further, the inorganic semiconductor material may be also a transparent oxide with a dopant added to ZnO, ln2O3, or the like.

An organic semiconductor layer includes, for example, any one or more kinds of the following organic semiconductor materials: (1) polypyrrole, (2) polythiophene, (3) isothianaphthene such as polyisothianaphthene, (4) thenylenevinylene such as polythenylenevinylene, (5) poly(p-phenylenevinylene) such as poly(p-phenylenevinylene), (6) polyaniline, (7) polyacetylene, (8) polydiacetylene, (9) polyazulene, (10) polypyrene, (11) polycarbazole, (12) polyselenophene, (13) polyfuran, (14) poly(p-phenylene), (15) polyindole, (16) polypyridazine, (17) acen such as naphthacene, pentacene, hexacene, heptacene, dibenzopentacene, tetrabenzopentacene, pyrene, dibenzopyrene, chrysene, perylene, coronene, terylene, ovalene, quaterrylene, and circumanthracene, (18) a derivative such as triphenodioxazine, triphenodithiazine, or hexacene-6, 15-quinone, wherein a part of carbon contained in acene group is substituted by atom such as nitrogen (N), sulfur (S), or oxygen (O), or a functional group including carbonyl group, (19) polymeric material and polycyclic condensate such as polyvinyl carbazole, polyphenylene sulfide, or polyvinylene sulfide, (20) oligomer having the same recurring unit as the above-described polymeric materials, (21) metallic phthalocyanine such as copper phthalocyanine, (22) tetrathiafulvalene, (23) tetrathiapentalene, (24) naphthalene 1, 4, 5, 8-tetracarboxylic acid diimide, N, N'-bis (4-trifluoromethylbenzil) naphthalene 1, 4, 5, 8-tetracarboxylic acid diimide, as well as N, N'-bis (1H, 1H-perfluorooctyl), N, N'-bis (1H, 1H-perfluorobutyl), N, N'-dioctylnaphthalene 1, 4, 5, 8-tetracarboxylic acid diimide derivative, (25) naphthalene tetracarboxylic acid diimide such as naphthalene 2, 3, 6, 7-tetracarboxylic acid diimide, (26) condensed ring tetracarboxylic acid diimide as typified by anthracene tetracarboxylic acid diimide group such as anthracene 2, 3, 6, 7- tetracarboxylic acid diimide, (27) fullerene such as C60, C70, C76, C78, and C84, (28) carbon nanotube such as single wall nanotube (SWNT), (29) pigment such as merocyanine dye and hemicyanine dye, and (30) peri-Xanthenoxanthene compound such as 2, 9-dinaphtyl-peri-Xanthenoxanthene.

In addition to these materials, the organic semiconductor material may be also a derivative of a range of materials described above. The derivative is a material with one or more substituents introduced to the above-described materials, and a type and introduced position of the substituents are arbitrary.

A portion located at the non-overlapping region R1 on the semiconductor layer 5 is a portion (so-called channel portion) essentially contributing to the electrical characteristics.

The source electrode 6 and the drain electrode 7 are formed to be separated from each other on the semiconductor layer 5, and each contain the same materials as for the gate electrode 3 for example.

As described above, the semiconductor layer 5 is separated from the gate electrode 3 with a separate insulating layer in between. Since the gate electrode 3 is located between the stepped insulating layer 2 and the gate insulating layer 4, the separate insulating layer is the gate insulating layer 4 in this case. In other words, a thickness of a separate insulating layer is represented by a thickness of the gate insulating layer 4. The thickness of the gate insulating layer 4 to separate the semiconductor layer 5 from the gate electrode 3 is not fixed, and varied depending on a location.

In concrete terms, as shown in FIG. 1B, the stepped insulating layer 2 is formed at least on the non-overlapping region R1 at the front surface of the support substrate 1, and the gate electrode 3 covers the stepped insulating layer 2 at the non-overlapping region R1, and the overlapping region R2 (support substrate 1). Consequently, a portion formed on the stepped insulating layer 2 at the gate electrode 3 is closer to the semiconductor layer 5 than a portion formed on the support substrate 1. Meanwhile, the front surface of the gate insulating layer 4 at a side close to the semiconductor layer 5 is almost flat. Therefore, by utilizing a step arising due to the presence or absence of the stepped insulating layer 2, a thickness T1 of the gate insulating layer 4 at the non-overlapping region R1 is made smaller than a thickness T2 of the gate insulating layer 4 at the overlapping region R2.

The reason why the thickness T1 is smaller than the thickness T2 is as follows: Since a distance between the gate electrode 3 and the semiconductor layer 5 becomes smaller at the non-overlapping region R1, these come closer to each other. This makes it difficult to decrease ON current. On the other hand, since a distance between the gate electrode 3 and the source electrode 6, and a distance between the gate electrode 3 and the drain electrode 7 become larger at the overlapping region R2, these get away from each other. This reduces a possibility that any leakage current flows between the gate electrode 3 and the source electrode 6, and between the gate electrode 3 and the drain electrode 7.

For a magnitude relation between the thickness T1 of the gate insulating layer 4 at the non-overlapping region R1 and the thickness T2 of the gate insulating layer 4 at the overlapping region R2, three kinds of cases are considered. Firstly, the thickness T1 at the non-overlapping region R1 may be smaller than the thickness T2 at the overlapping region R2 of the gate electrode 3 and the source electrode 6, and may be smaller than the thickness T2 at the overlapping region R2 of the gate electrode 3 and the drain electrode 7. Secondly, the thickness T1 at the non-overlapping region R1 may be smaller than the thickness T2 at the overlapping region R2 of the gate electrode 3 and the source electrode 6, while may be almost identical to the thickness T2 at the overlapping region R2 of the gate electrode 3 and the drain electrode 7. Thirdly, the thickness T1 at the non-overlapping region R1 may be almost identical to the thickness T2 at the overlapping region R2 of the gate electrode 3 and the source electrode 6, while may be smaller than the thickness T2 at the overlapping region R2 of the gate electrode 3 and the drain electrode 7. This is because the above-described benefit is obtained if there is even only one location where the thickness T1 is smaller than the thickness T2. Above all, the first case is preferable. This is because the probability of occurrence of leakage current is further reduced, which assures enhanced advantageous effect.

It is to be noted that shapes (planar shapes) of the source electrode 6 and the drain electrode 7 are not limited especially. In this case, as shown in FIG. 1A, for example, the source electrode 6 includes a comb-shaped portion 6B having a plurality of branch portions 6A that are divergent at one end side, and similarly the drain electrode 7 also includes a comb-shaped portion 7B having a plurality of divergent branch portions 7A. Consequently, the source electrode 6 and the drain electrode 7 are disposed to engage with each other at the comb-shaped portions 6B and 7B. This "engaging with each other" means a state where each of the branch portions 7A of the drain electrode 7 comes into each space provided between the branch portions 6A on the source electrode 6, while each of the branch portions 6A of the source electrode 6 comes into each space provided between the branch portions 7A of the drain electrode 7.

In this case, as shown in FIG. 1B for example, the gate electrode 3 is provided as a solid film at least on a region where the source electrode 6 and the drain electrode 7 engage with each other. In other words, the gate electrode 3 is not formed to be divided for each channel region (non-overlapping region R1) between the source electrode 6 and the drain electrode 7, but is formed over a whole area of a region including a plurality of channel regions. If the gate electrode 3 is formed as a solid film at the region including the plurality of channel regions in such a manner, the gate electrode 3 of the solid film may be formed to be divided into a plurality of regions. In this case, by making a difference in the thicknesses T1 and T2 of the gate insulating layer 4, it is possible to obtain the above-described benefit even if the gate electrode 3 is formed as a solid film.

It is to be noted that either the source electrode 6 or the drain electrode 7 may only have a comb shape. More specifically, for example, the source electrode 6 has the comb-shaped portion 6B, whereas the drain electrode 7 may take a non-branched shape (linear shape). In this case, one end of the drain electrode 7 may come into each space provided between the branch portions 6A of the source electrode 6 to ensure that the source electrode 6 and the drain electrode 7 engage with each other. Also in such a case, the similar advantageous effect is achievable. As a matter of course, the drain electrode 7 has the comb-shaped portion 7B, whereas the source electrode 6 may take a non-branched shape.

Next, a method of manufacturing the above-described TFT is described with reference to FIG. 1. It is to be noted that materials for forming each component of the TFT have been already described in details, and thus an example of such materials is given hereinafter.

When the TFT is manufactured, at the beginning, the stepped insulating layer 2 is selectively formed on the support substrate 1 of a plastic film such as polyimide. In this case, for example, a photoresist film (not shown in the figure) is formed by coating a photoresist on the front surface of the support substrate 1, and then the photoresist film is patterned (exposed and developed) using a photolithographic method and the like. As an example of this photoresist, it is possible to use the TELP-P003PM manufactured by Tokyo Ohka Kogyo Co., Ltd. Further, a position for forming the stepped insulating layer 2 is aligned to be formed at least on the non-overlapping region R1, not on the overlapping region R2.

It is to be noted that, in forming the stepped insulating layer 2, for example, a film is deposited with an inorganic insulating material or an organic insulating material to cover the front surface of the support substrate 1, and thereafter patterning may be performed using a method other than a photolithographic method. Examples of this patterning method include a dry etching method. Alternatively, the stepped insulating layer 2 may be formed utilizing an ink jet method, a screen printing method, an offset printing method or a gravure printing method, a nanoimprint method, or the like.

Subsequently, the gate electrode 3 is formed to cover the stepped insulating layer 2 at the non-overlapping region R1 and the support substrate 1 at the overlapping region R2 in a surrounding area thereof. In this case, for example, a metallic material layer (not shown in the figure) is formed to cover the stepped insulating layer 2 and the support substrate 1, and then the metallic material layer is patterned.

Examples of a material for forming the metallic material layer include aluminum and the like, and examples of a method for forming such a layer include a spattering method and a gas phase growth method such as a vapor deposition method and a chemical vapor deposition (CVD) method. Further, a method for patterning the metallic material layer is, for example, an etching method. This etching method may be a dry etching method such as an ion milling method and a reactive ion etching (RIE) method, or a wet etching method.

It is to be noted that, in patterning the metallic material layer, a photolithographic method or an ultraviolet lithography method may be used together therewith. In this case, for example, a photoresist is coated on the front surface of the metallic material layer to form a photoresist film, which is patterned using a photolithographic method or the like, and then the metallic material layer is etched using the photoresist film as a mask. Alternatively, a metallic film or the like may be used as a mask instead of the photoresist film.

Next, the gate insulating layer 4 is formed to cover the gate electrode 3. In this case, for example, a solution in which a PVP is dissolved in an arbitrary organic solvent is prepared, and then the solution is coated and dried. Examples of such a coating method include a spin coat method, an air doctor coater method, a blade coater method, a rod coater method, a knife coater method, a squeeze coater method, a reverse roll coater method, a transfer roll coater method, a gravure coater method, a kiss coater method, a cast coater method, a spray coater method, a slit orifice coater method, a calendar coater method, a dipping method, and the like. In this case, heating may be performed to increase the drying speed as appropriate.

In a process of forming the gate insulating layer 4, since the front surface of a solution with the fluidity is subject to leveling during or after coating, the front surface of the gate insulating layer 4 is planarized although the underlying front surface has an uneven shape due to the presence of the stepped insulating layer 2. As a result, at the time of forming the gate insulating layer 4, the thickness T1 of the gate insulating layer 4 at the non-overlapping region R1 becomes smaller than the thickness T2 of the gate insulating layer 4 at the overlapping region R2.

It is to be noted that the gate insulating layer 4 may be formed utilizing the same method as a method for forming the metallic material layer that is used to form the gate electrode 3. In this case, the front surface of the gate insulating layer 4 may be planarized as appropriate to make the thickness T1 smaller than the thickness T2 as described above. This planarizing method is, for example, an etching method or a polishing method.

Subsequently, the semiconductor layer 5 is formed on the gate insulating layer 4. A material to be used for forming an organic semiconductor layer as the semiconductor layer 5 is, for example, pentacene or the like. Further, examples of a method for forming the semiconductor layer 5 include (1) gas phase growth methods such as a resistance heating vapor deposition method, a spattering method, a vapor deposition method, and a CVD method, and (2) coating methods such as a spin coat method, an air doctor coater method, a blade coater method, a rod coater method, a knife coater method, a squeeze coater method, a reverse roll coater method, a transfer roll coater method, a gravure coater method, a kiss coater method, a cast coater method, a spray coater method, a slit orifice coater method, a calendar coater method, a dipping method, or the like. These formation methods are selectable as appropriate according to the requirements of a material for forming the semiconductor layer 5. It is to be noted that a thickness of the semiconductor layer 5 is not limited especially, although is approximately 50 nm for example.

In a process of forming the semiconductor layer 5, the semiconductor layer 5 is formed on the flat gate insulating layer 4, and thus the semiconductor layer 5 is also formed in a flat state.

Finally, the source electrode 6 and the drain electrode 7 that are separated from each other are formed on the semiconductor layer 5. In this case, for example, a metallic material layer (not shown in the figure) is formed to cover at least the front surface of the semiconductor layer 5, and then the metallic material layer is patterned.

A material for forming the metallic material layer is, for example, gold and the like, and a method for forming such a layer is, for example, the same as a method for forming the gate electrode 3. However, as a patterning method of the metallic material layer, a wet etching method that gives less damaging to the semiconductor layer 5 is preferable.

In this TFT, the semiconductor layer 5 is separated from the gate electrode 3 with a separate insulating layer (gate insulating layer 4) in between. Further, the thickness T1 of the gate insulating layer 4 at the non-overlapping region R1 is smaller than the thickness T2 of the gate insulating layer 4 at the overlapping region R2. This makes it possible to easily achieve the performance improvement of the TFT for a reason given below.

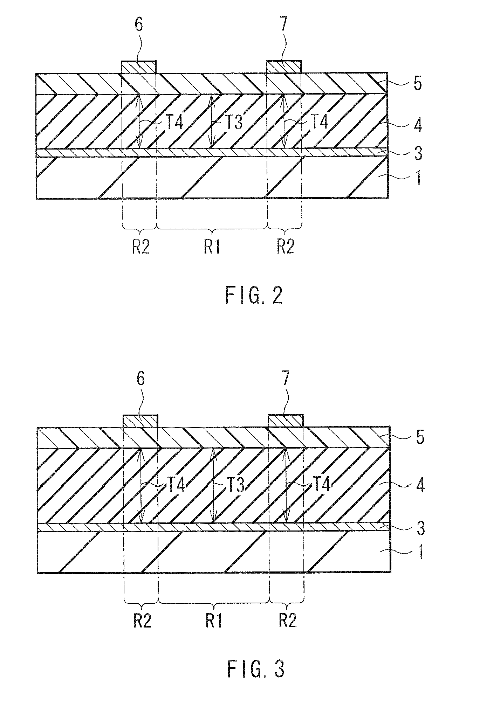

FIG. 2 and FIG. 3, which show a configuration of a TFT in a comparative example, both illustrate a cross-sectional structure corresponding to FIG. 1B. The TFT in this comparative example is not provided with the stepped insulating layer 2, and has the same configuration as the TFT shown in FIGs. 1A and 1B except that a thickness T3 of the gate insulating layer 4 at the non-overlapping region R1 is identical to a thickness T4 of the gate insulating layer 4 at the overlapping region R2. It is to be noted that each of the thicknesses T3 and T4 is equal to T1 in FIG. 2, while each of the thicknesses T3 and T4 is equal to T2 in FIG. 3.

In a comparative example illustrated in FIG. 2, since the semiconductor layer 5 comes close to the gate electrode 3 at the non-overlapping region R1, ON current increases, whereas the source electrode 6 and the drain electrode 7 also come close to the gate electrode 3 at the overlapping region R2, and thus leakage current is likely to flow between these electrodes. Further, in a comparative example illustrated in FIG. 3, since the source electrode 6 and the drain electrode 7 get away from the gate electrode 3 at the overlapping region R2, leakage current is less likely to flow between these electrodes. On the other hand, since the semiconductor layer 5 gets away from the gate electrode 3 at the non-overlapping region R1, ON current decreases.

On the contrary, in this embodiment of the present disclosure as shown in FIGs. 1A and 1B, as described above, since the source electrode 6 and the drain electrode 7 get away from the gate electrode 3 at the overlapping region R2, leakage current is less likely to flow between these electrodes. Further, since the semiconductor layer 5 comes close to the gate electrode 3 at the non-overlapping region R1, ON current increases. In addition, it is possible to use an existing material as a material for forming the gate insulating layer 4, as well as to easily obtain the above-described benefit without using a complicated method such as surface modification. This makes it possible to easily achieve the performance improvement of the TFT.

In particular, if the stepped insulating layer 2 is formed only at the non-overlapping region R1, it is possible to easily make the thickness T1 smaller than the thickness T2 by making use of a step arising from the presence or absence of the stepped insulating layer 2. In this case, if the front surface of the gate insulating layer 4 at a side close to the semiconductor layer 5 is flat, it is possible to assuredly make the thickness T1 smaller than the thickness T2 by making use of the stepped insulating layer 2. In addition, when the semiconductor layer 5 is an organic semiconductor layer, if the semiconductor layer 5 is flat, the alignment property of organic semiconductor molecules is improved, thereby allowing the performance of the TFT to be further enhanced.

An example is now provided of modifying the above-described technology for TFT type.

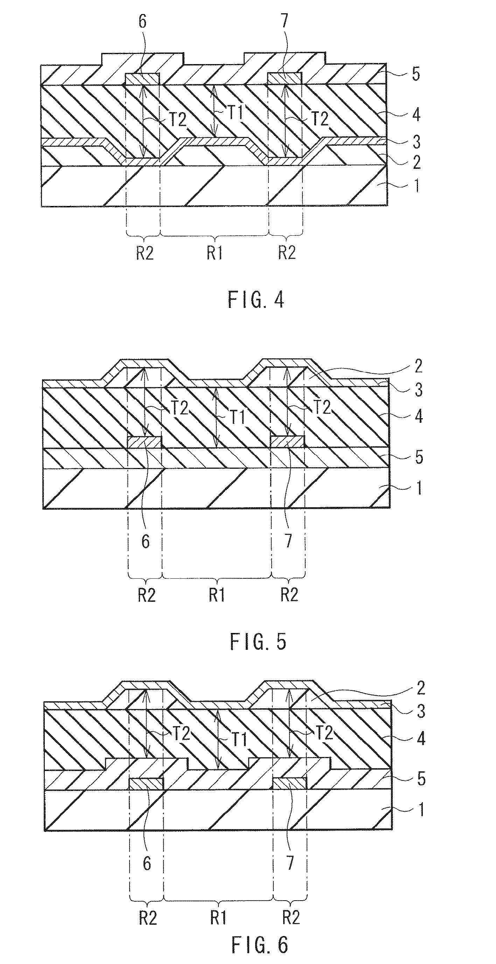

FIG. 1B shows a bottom gate/top contact type TFT, although the TFT type is not limited to such a type. For example, the TFT may be a bottom gate/bottom contact type shown in FIG. 4, a top gate/top contact type shown in FIG. 5, or a top gate/bottom contact type shown in FIG. 6. The configuration and manufacturing method of these TFTs are the same as those of the TFT as shown in FIGs. 1A and 1B except that a stacking order of a series of components is different.

As shown in FIG. 4, a bottom gate/bottom contact type TFT includes the stepped insulating layer 2, the gate electrode 3, the gate insulating layer 4, the source electrode 6 and the drain electrode 7, as well as the semiconductor layer 5 in this order on the support substrate 1. A separate insulating layer that makes a difference in the thicknesses T1 and T2 in this TFT is the gate insulating layer 4 as with a bottom gate/top contact type. Therefore, a thickness of the separate insulating layer is expressed by the thickness of the gate insulating layer 4.

As shown in FIG. 5, a top gate/top contact type TFT includes the semiconductor layer 5, the source electrode 6 and the drain electrode 7, the gate insulating layer 4, the stepped insulating layer 2, and the gate electrode 3 in this order on the support substrate 1. A separate insulating layer that makes a difference in the thicknesses T1 and T2 in this TFT is the gate insulating layer 4 and the stepped insulating layer 2 unlike the bottom gate/top contact type. Therefore, a thickness of the separate insulating layer is expressed by a sum of the thickness of the gate insulating layer 4 and the thickness of the stepped insulating layer 2.

As shown in FIG. 6, a top gate/bottom contact type TFT includes the source electrode 6 and the drain electrode 7, the semiconductor layer 5, the gate insulating layer 4, the stepped insulating layer 2, and the gate electrode 3 in this order on the support substrate 1. A separate insulating layer that makes a difference in the thicknesses T1 and T2 in this TFT is the gate insulating layer 4 and the stepped insulating layer 2 as with the top gate/top contact type. Therefore, a thickness of the separate insulating layer is expressed by a sum of a thickness of the gate insulating layer 4 and a thickness of the stepped insulating layer 2.

In these TFTs as well, the thickness T1 of the separate insulating layer at the non-overlapping region R1 becomes smaller than the thickness T2 of the separate insulating layer at the overlapping region R2, which allows the same operation and advantageous effect as the bottom gate/top contact type (FIGs. 1A and 1B) to be achieved.

However, in the TFT including an organic semiconductor layer as the semiconductor layer 5, as described above, the alignment property of organic semiconductor molecules is improved if the semiconductor layer 5 is flat. Therefore, the bottom gate/top contact type or the top gate/top contact type that makes it easy to form the semiconductor layer 5 in a flat state is preferable.

An example is now provided of modifying the above-described technology in relation to the position for forming stepped insulating layer.

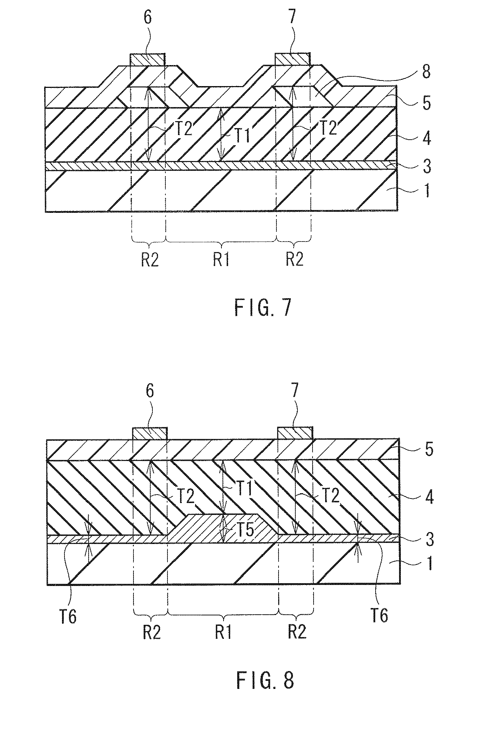

In FIG. 1B, the stepped insulating layer 2 is formed on the support substrate 1 to make a difference in the thicknesses T1 and T2, although a position for forming the stepped insulating layer 2 may be changed. For example, in the bottom gate/top contact type TFT, as shown in FIG. 7, the stepped insulating layer 2 may be formed at least on the overlapping region R2 on the gate insulating layer 4. A separate insulating layer that makes a difference in the thicknesses T1 and T2 in this TFT is the gate insulating layer 4 and the stepped insulating layer 2. Therefore, a thickness of the separate insulating layer is expressed by a sum of a thickness of the gate insulating layer 4 and a thickness of the stepped insulating layer 2. In this case as well, the thickness T1 of the separate insulating layer at the non-overlapping region R1 becomes smaller than the thickness T2 of the separate insulating layer at the overlapping region R2, which allows the same advantageous effect to be achieved.

As a matter of course, in the TFTs shown in FIG. 4 to FIG. 6, a position for forming the stepped insulating layer 2 may be changed. However, when the semiconductor layer 5 is an organic semiconductor layer, to planarize the semiconductor layer 5 for improving the alignment property of organic semiconductor molecules, it is preferable not to form the stepped insulating layer 2 directly below the semiconductor layer 5. In other words, for the bottom gate/top contact type, a configuration shown in FIG. 1B is more preferable than a configuration shown in FIG. 7.

An example is now provided of modifying the above-described technology in relation to the configuration making difference in thicknesses T1 and T2.

In the bottom gate-top contact type TFT as shown in FIG. 1B, a difference is made in the thicknesses T1 and T2 by making use of a step arising from the presence or absence of the stepped insulating layer 2, although the configuration is not limited thereto. For example, as shown in FIG. 8, a thickness of the gate electrode 3 may be made different at the non-overlapping region R1 and the overlapping region R2 instead of forming the stepped insulating layer 2. In concrete terms, to make the thickness T1 smaller than the thickness T2, a thickness T5 of the gate electrode 3 at the non-overlapping region R1 may be made larger than a thickness T6 of the gate electrode 3 at the overlapping region R2. A separate insulating layer that makes a difference in the thicknesses T1 and T2 in this TFT is the gate insulating layer 4. Therefore, a thickness of the separate insulating layer is expressed by a thickness of the gate insulating layer 4.

In forming the gate electrode 3, for example, the gate electrode 3 with the thickness T5 is formed at the non-overlapping region R1 and the overlapping region R2, and then the gate electrode 3 at the overlapping region R2 may be etched. This etching method is, for example, a dry etching method such as an ion milling method or an RIE method. Alternatively, for example, the gate electrode 3 with the thickness T6 is formed at the non-overlapping region R1 and the overlapping region R2, and then the gate electrode 3 may be additionally formed at the non-overlapping region R1. In this case, the gate electrode 3 at the non-overlapping region R1 is structured in two layers. However, the gate electrode 3 formed at the non-overlapping region R1 is not limited to a two-layered structure, and may be structured in three or more layers. As a matter of course, the gate electrode 3 at the non-overlapping region R1 and the gate electrode 3 at the overlapping region R2 may be formed in separate processes.

In this case as well, by utilizing a difference in the thicknesses T5 and T6 of the gate electrode 3, the thickness T1 of the separate insulating layer at the non-overlapping region R1 is made smaller than the thickness T2 of the separate insulating layer at the overlapping region R2, which allows the same advantageous effect to be achieved.

As a matter of course, in the bottom gate type TFT shown in FIG. 4 and FIG. 7, a difference may be made in thicknesses of the gate electrode 3 instead of forming the stepped insulating layer 2. The bottom gate type allows the same operation and advantageous effect as with a case as illustrated in FIG. 8 to be achieved. Alternatively, as with a case where a difference is made in the thicknesses T5 and T6 of the gate electrode 3 instead of forming the stepped insulating layer 2, a difference may be made in the thicknesses T1 and T2 in such a manner that the gate insulating layer 4 is formed, and then a part thereof is etched, or a part of the gate insulating layer 4 is structured in two or more layers.

It is to be noted that one or more kinds of a series of embodiments described above with reference to FIG. 1 and FIG. 4 to FIG. 8 may be combined arbitrarily.

Next, the description is provided on application examples of the above-described TFT. This TFT is, for example, applicable to several electronic units as described hereinafter.

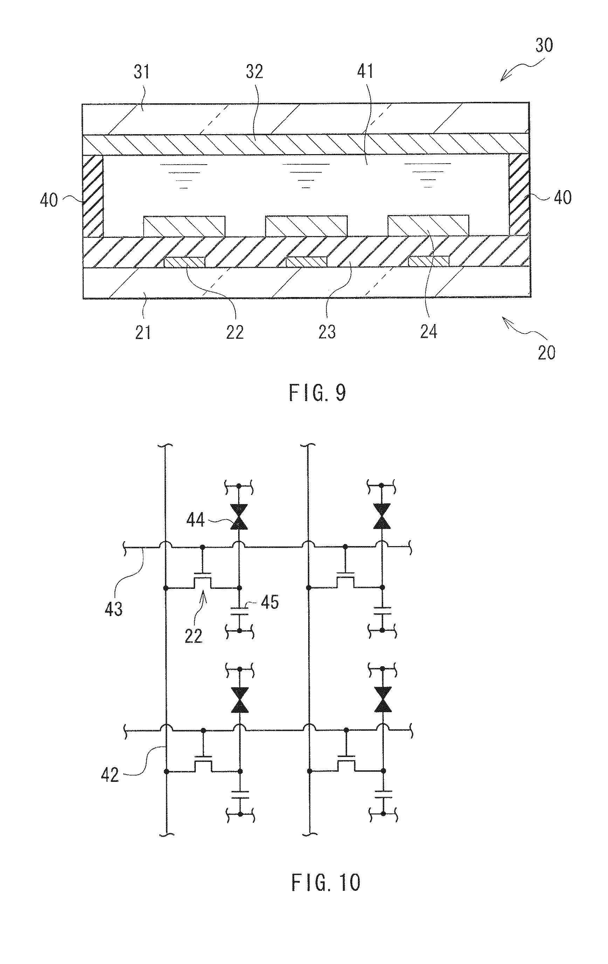

The TFT is, for example, applicable to a liquid crystal display. FIG. 9 and FIG. 10 show a cross-sectional structure and a circuit configuration of a liquid crystal display, respectively. It is to be noted that a unit structure (FIG. 9) and a circuit configuration (FIG. 10) are illustrative only, and such a structure and configuration may be modified as appropriate.

A liquid crystal display to be described here is, for example, a transmission-type liquid crystal display of an active matrix drive method using a TFT, wherein the TFT is used as a device for switching (pixel selection). As shown in FIG. 9, on this liquid crystal display, a liquid crystal layer 41 is sealed between a drive substrate 20 and a facing substrate 30.

In the drive substrate 20, for example, TFTs 22, a planarized insulating layer 23, and pixel electrodes 24 are laminated in this order on one side of a support substrate 21, and each of the TFTs 22 and the pixel electrodes 24 are disposed in a matrix pattern. It is to be noted that the number of the TFT 22 included within a single pixel may be one, or two or more. FIG. 9 and FIG. 10 illustrate, for example, a case where one TFT 22 is included within a single pixel.

The support substrate 21 is formed of a transparent material such as a glass and plastic material, and the TFT 22 has the same configuration as the TFT described above. A type of a plastic material is the same as with a case described about the above-mentioned TFT for example, and this is also true of a plastic material to be described hereinafter. The planarized insulating layer 23 contains, for example, an insulating resin material such as polyimide, while the pixel electrode 24 contains, for example, a transparent conductive material such as ITO. It is to be noted that the pixel electrode 24 is connected with the TFT 22 through a contact hole (not shown in the figure) that is provided on the planarized insulating layer 23.

In the facing substrate 30, for example, an facing electrode 32 is formed over a whole area on one side of a support substrate 31. The support substrate 31 is formed of a transparent material such as a glass and plastic material, and the facing electrode 32 includes, for example, a transparent conductive material such as ITO.

The drive substrate 20 and the facing substrate 30 are disposed so that the pixel electrode 24 and the facing electrode 32 are opposed to each other with a liquid crystal layer 41 interposed between, being stuck with a sealing material 40. A type of liquid crystal molecules contained in the liquid crystal layer 41 is selectable arbitrarily.

In addition, the liquid crystal display may include other components (not shown in the figure) such as a retardation plate, a polarizing plate, an alignment film, and a backlight unit.

As shown in FIG. 10 for example, a circuit for driving the liquid crystal display includes a capacitor 45 along with the TFT 22 and a liquid crystal display device 44 (device section including the pixel electrode 24, the facing electrode 32, and the liquid crystal layer 41). In this circuit, a plurality of signal lines 42 are arranged in a row direction, while a plurality of scan lines 43 are arranged in a column direction, and the TFT 22, the liquid crystal display device 44, and the capacitor 45 are disposed at positions where the signal lines 42 and the scan lines 43 intersect with each other. Connection points of the source electrode, the gate electrode and the drain electrode in the TFT 22 are not limited to the embodiment as shown in FIG. 10, but are allowed to be changed arbitrarily. The signal lines 42 and the scan lines 43 are connected with a signal line drive circuit (data driver) and a scan line drive circuit (scan driver) that are not shown in the figure.

In this liquid crystal display, when the liquid crystal display device 44 is selected by the TFT 22, and an electric field is applied across the pixel electrode 24 and the facing electrode 32, the alignment state of the liquid crystal molecules in the liquid crystal layer 41 changes depending on the electric field intensity. This controls the light transmission amount (transmittance) depending on the alignment state of the liquid crystal molecules, thereby displaying images.

In this liquid crystal display, since the TFT 22 has the same configuration as the above-described TFT, ON current increases and leakage current is less likely to flow in the TFT 22 by making use of an existing material without utilizing a complicated method. This allows the display performance to be improved with ease. It is to be noted that the liquid crystal display is not limited to a transmission type, but may be a reflective type.

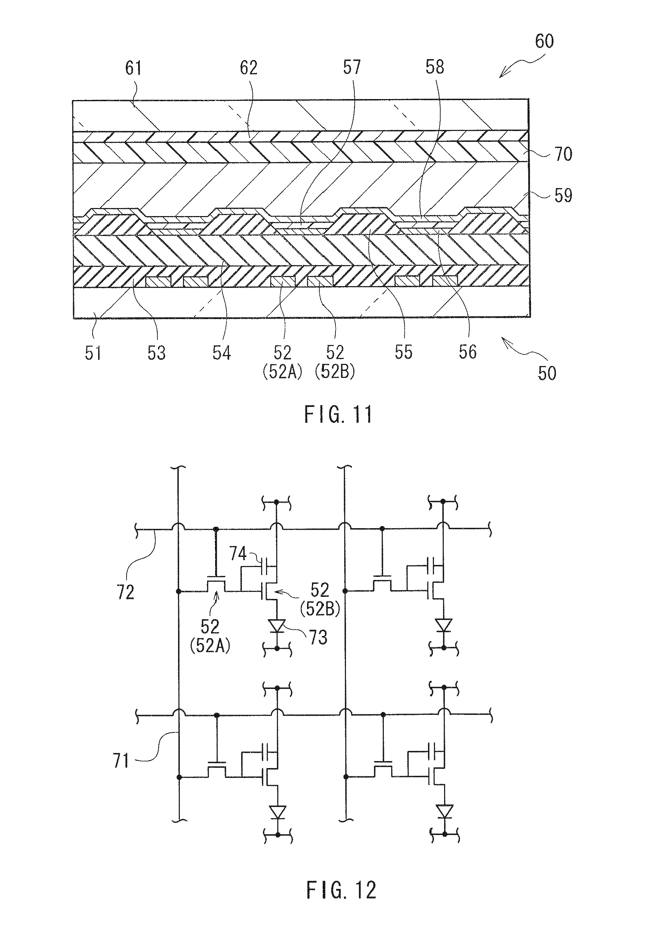

The TFT is, for example, applicable to an organic EL display. FIG. 11 and FIG. 12 show a cross-sectional structure and a circuit configuration of an organic EL display, respectively. It is to be noted that a unit structure (FIG. 11) and a circuit configuration (FIG. 12) are illustrative only, and such a structure and configuration may be changed as appropriate.

An organic EL display to be described here is, for example, an organic EL display of an active matrix drive method using a TFT as a switching device. This organic EL display, wherein a drive substrate 50 and a facing substrate 60 are stuck with an adhesive layer 70 in between, is, for example, a top emission type that emits light via the facing substrate 60.

In the drive substrate 50, for example, a TFT 52, a protective layer 53, a planarized insulating layer 54, a pixel separation insulating layer 55, a pixel electrode 56, an organic layer 57, a facing electrode 58, and a protective layer 59 are laminated in this order on one side of a support substrate 51. The TFT 52, the pixel electrode 56, and the organic layer 57 are disposed in a matrix pattern. It is to be noted that the number of the TFT 52 included within a single pixel may be one, or two or more. FIG. 11 and FIG. 12 illustrate, for example, a case where two TFTs 52 (TFT 52A for selection and TFT 52B for driving) are included within a single pixel.

The support substrate 51 is formed of, for example, a glass or plastic material. Since light is taken out of the facing substrate 60 in a top emission type, the support substrate 51 may be formed of either a transparent material or a non-transparent material. The TFT 52 has the same configuration as the TFT described above, and the protective layer 53 includes, for example, a polymeric material such as PVA and polyparaxylene. The planarized insulating layer 54 and the pixel separation insulating layer 55 contain, for example, an insulating resin material such as polyimide. It is preferable that the pixel separation insulating layer 55 contain a photosensitive resin material that is shapable using the light patterning or reflow to simplify a formation process and allow formation in a desired shape for example. It is to be noted that the planarized insulating layer 54 is not necessary if the flatness is sufficiently assured by the protective layer 53.

The pixel electrode 56 contains, for example, a reflective material such as aluminum, silver, titanium, or chromium, while the facing electrode 58 contains, for example, a transparent conductive material such as ITO and IZO. It is to be noted that the facing electrode 58 may contain a transparent metallic material such as calcium (Ca) or alloy thereof, and a transparent organic conductive material such as PEDOT. The organic layer 57 includes a light emitting layer to emit red, green, or blue light, and may have a laminated structure including a hole transport layer and an electron transport layer as appropriate. A material for forming the light emitting layer is selectable arbitrarily according to a color of light to be generated. The pixel electrode 56 and the organic layer 57 are disposed in a matrix pattern while being separated by the pixel separation insulating layer 55, whereas the facing electrode 58 extends continuously in opposition to the pixel electrode 56 via the organic layer 57. The protective layer 59 contains, for example, a light transmission dielectric material such as silicon oxide, aluminum oxide, silicon nitride, polyparaxylene, and urethane. It is to be noted that the pixel electrode 56 is connected with the TFT 52 through contact holes (not shown in the figure) that are provided on the protective layer 53 and the planarized insulating layer 54.

In the facing substrate 60, for example, a color filter 62 is provided on one side of a support substrate 61. The support substrate 61 is formed of a transparent material such as a glass and plastic material, and the color filter 62 has a plurality of color regions corresponding to colors of light generated on the organic layer 57. It is to be noted that the color filter 62 may be omitted.

The adhesive layer 70 is, for example, an adhesive material such as a thermosetting resin.

As shown in FIG. 12 for example, a circuit for driving the organic EL display includes a capacitor 74 along with the TFTs 52 (TFT 52A for selection and TFT 52B for driving) and an organic EL display device 73 (device section including the pixel electrode 56, the organic layer 57, and the facing electrode 58). In this circuit, the TFT 52, the organic EL display device 73, and the capacitor 74 are disposed at positions where a plurality of signal lines 71 and scan lines 72 intersect with each other. Connection points of the source electrode, the gate electrode and the drain electrode in the TFT 52A for selection and TFT 52B for driving are not limited to the configuration as shown in FIG. 12, but are allowed to be changed arbitrarily.

In this organic EL display, for example, when the organic EL display device 73 is selected by the TFT 52A for selection, the organic EL display device 73 is driven by the TFT 52B for driving. In this case, when an electric field is applied across the pixel electrode 56 and the facing electrode 58, light is generated on the organic layer 57. As a result, for example, red, green, or blue light are generated respectively at three adjacent organic EL display devices 73. Synthesized light of these light beams is emitted to the outside via the facing substrate 60, thereby displaying images.

In this organic EL display, the TFT 52 has the same configuration as the above-described TFT, which allows the display performance to be improved easily as with the liquid crystal display.

It is to be noted that the organic EL display is not limited to a top emission type, but may be a bottom emission type that emits light via the drive substrate 50, or may be a dual emission type that emits light via both of the drive substrate 50 and the facing substrate 60. In this case, the electrode at a side where light is emitted between the pixel electrode 56 and the facing electrode 58 is formed of a transparent material, and the electrode at a side where no light is emitted is formed of a reflective material.

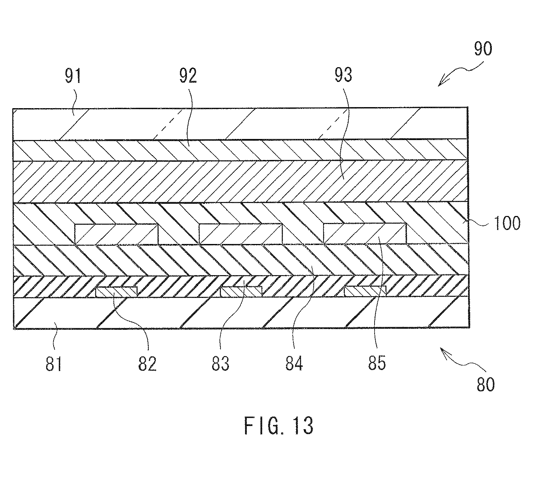

The TFT is, for example, applicable to an electronic paper display. FIG. 13 shows a cross-sectional structure of an electronic paper display. It is to be noted that a unit structure (FIG. 13) to be described hereinafter, and a circuit configuration to be described with reference to FIG. 10 are illustrative only, and such a structure and configuration may be modified as appropriate.

An electronic paper display to be described here is, for example, an electronic paper display of an active matrix drive method using a TFT as a switching device. In this electronic paper display, for example, a drive substrate 80 and a facing substrate 90 including electrophoretic devices 93 are stuck with an adhesive layer 100 in between.

In the drive substrate 80, for example, a TFT 82, a protective layer 83, a planarized insulating layer 84, and a pixel electrode 85 are laminated in this order on one side of a support substrate 81, and the TFT 82 and the pixel electrode 85 are disposed in a matrix pattern. The support substrate 81 is formed of, for example, a glass or plastic material, and the TFT 82 has the same configuration as the TFT described above. The protective layer 83 and the planarized insulating layer 84 include, for example, an insulating resin material such as polyimide, and the pixel electrode 85 includes, for example, a metallic material such as silver. It is to be noted that the pixel electrode 85 is connected with the TFT 82 through contact holes (not shown in the figure) that are provided on the protective layer 83 and the planarized insulating layer 84. Further, the planarized insulating layer 84 is not necessary if the flatness is sufficiently assured by the protective layer 83.

In the facing substrate 90, for example, a facing electrode 92 and a layer including a plurality of electrophoretic devices 93 are laminated in this order and the facing electrode 92 is formed over a whole area on one side of a support substrate 91. The support substrate 91 is formed of, for example, a transparent material such as a glass and plastic material, and the facing electrode 92 contains, for example, a transparent conductive material such as ITO. The electrophoretic devices 93 generate the contrast utilizing the electrophoretic phenomenon, and configuration thereof is arbitrary.

In addition, the electronic paper display may include other components (not shown in the figure) such as a color filter.

A circuit for driving the electronic paper display has the same configuration as a circuit of the liquid crystal display as shown in FIG. 10 for example. The circuit of the electronic paper display includes the TFT 82 and an electronic paper display device (device section including the pixel electrode 85, the facing electrode 92, and the electrophoretic devices 93) instead of the TFT 22 and the liquid crystal display device 44.

In this electronic paper display, when the electronic paper display device is selected by the TFT 82, and an electric field is applied across the pixel electrode 85 and the facing electrode 92, the electrophoretic devices 93 generate the contrast depending on the electric field, thereby displaying images.

In this electronic paper display, the TFT 82 has the same configuration as the above-described TFT, which allows the display performance to be improved easily as with the liquid crystal display.

The present technology is described hitherto by citing the embodiment, although the present technology is not limited to this embodiment of the present disclosure, and various modifications are available. For example, the electronic unit to which the thin-film transistor of the present technology is applicable is not limited to the liquid crystal display, the organic EL display, or the electronic paper display, but may be any other display. Examples of such other displays include MEMS (Micro Electro Mechanical Systems) display (MEMS-type display) and the like. In this case as well, it is possible to improve the display performance.

Further, for example, the thin-film transistor of the present technology may be applicable to electronic devices other than the display. Examples of such electronic devices include a sensor matrix, a memory sensor, an RFID (Radio Frequency Identification) tag, and a sensor array. In this case as well, it is possible to improve the display performance.

It is to be noted that the present technology may be configured as follows.
(1) A thin-film transistor, including: a gate electrode; a semiconductor layer separated from the gate electrode with a separation insulating layer in between; and a source electrode and a drain electrode that are connected with the semiconductor layer and are separated from each other, wherein, between the source electrode and the drain electrode, a thickness of the separation insulating layer at a first region where the gate electrode does not overlap both the source electrode and the drain electrode is smaller than a thickness of the separation insulating layer at a second region where the gate electrode overlaps one or both of the source electrode and the drain electrode.
(2) The thin-film transistor according to (1), wherein the semiconductor layer is an organic semiconductor layer.
(3) The thin-film transistor according to (1) or (2), wherein the separation insulating layer includes a gate insulating layer, and the gate insulating layer contains an organic insulating material.
(4) The thin-film transistor according to any one of (1) to (3), wherein a thickness of the separation insulating layer at the first region is smaller than a thickness of the separation insulating layer at the second region where the gate electrode and the source electrode overlap each other, and is smaller than a thickness of the separation insulating layer at the second region where the gate electrode and the drain electrode overlap each other.
(5) The thin-film transistor according to any one of (1) to (4), further including: a stepped insulating layer provided at the first region; and a gate insulating layer provided between the gate electrode and all of the semiconductor layer, the source electrode, and the drain electrode, wherein the gate electrode is located between the stepped insulating layer and the gate insulating layer at the first region, and the separation insulating layer is the gate insulating layer, and a thickness of the separation insulating layer is expressed by a thickness of the gate insulating layer.
(6) The thin-film transistor according to (5), wherein the gate electrode is formed to cover the stepped insulating layer provided at the first region and the second region, the gate insulating layer is formed on the gate electrode, the semiconductor layer is formed on the gate insulating layer, and the source electrode and the drain electrode are formed on the semiconductor layer.
(7) The thin-film transistor according to (5), wherein the gate electrode is formed to cover the stepped insulating layer provided at the first region, and the second region, the gate insulating layer is formed on the gate electrode, the source electrode and the drain electrode are formed on the gate insulating layer, and the semiconductor layer is formed on the gate insulating layer, the source electrode, and the drain electrode.
(8) The thin-film transistor according to any one of (1) to (4), further including: a stepped insulating layer provided at the second region; and a gate insulating layer provided between all of the semiconductor layer, the source electrode and the drain electrode, and the stepped insulating layer, wherein the stepped insulating layer is located between the gate insulating layer and the gate electrode at the second region, and the separation insulating layer is the gate insulating layer and the stepped insulating layer, and a thickness of the separation insulating layer is expressed by a sum of a thickness of the gate insulating layer and a thickness of the stepped insulating layer.
(9) The thin-film transistor according to (8), wherein the source electrode and the drain electrode are formed on the semiconductor layer, the gate insulating layer is formed on the semiconductor layer, the source electrode, and the drain electrode, the stepped insulating layer is formed on the gate insulating layer at the second region, and the gate electrode is formed to cover the gate insulating layer and the stepped insulating layer provided at the second region.
(10) The thin-film transistor according to (8), wherein the semiconductor layer is formed to cover the first region and the source electrode and the drain electrode provided at the second region, the gate insulating layer is formed on the semiconductor layer, the stepped insulating layer is formed on the gate insulating layer at the second region, and the gate electrode is formed to cover the gate insulating layer and the stepped insulating layer provided at the second region.
(11) The thin-film transistor according to any one of (1) to (4), wherein a thickness of the gate electrode at the first region is greater than a thickness of the gate electrode at the second region.
(12) The thin-film transistor according to (11), further including: a gate insulating layer provided between the gate electrode and the semiconductor layer, wherein the separation insulating layer is the gate insulating layer, and a thickness of the separation insulating layer is expressed by a thickness of the gate insulating layer.
(13) The thin-film transistor according to (12), wherein the gate insulating layer is formed to cover the gate electrode provided at the first region and the second region, the semiconductor layer is formed on the gate insulating layer, and the source electrode and the drain electrode are formed on the semiconductor layer.
(14) The thin-film transistor according to any one of (1) to (13), wherein one or both of the source electrode and the drain electrode includes a comb-shaped portion having a plurality of divergent branch portions, the source electrode and the drain electrode are disposed to engage with each other at the comb-shaped portion, and the gate electrode is provided as a solid film in at least a region where the source electrode and the drain electrode engage with each other.
(15) An electronic unit with a thin-film transistor, the thin-film transistor including: a gate electrode; a semiconductor layer separated from the gate electrode with a separation insulating layer in between; and a source electrode and a drain electrode that are connected with the semiconductor layer and are separated from one another, wherein, between the source electrode and the drain electrode, a thickness of the separation insulating layer at a first region where the gate electrode does not overlap both the source electrode and the drain electrode is smaller than a thickness of the separation insulating layer at a second region where the gate electrode overlaps one or both of the source electrode and the drain electrode.

The present disclosure contains subject matter related to that disclosed in Japanese Priority Patent Application JP 2011-19$457 filed in the Japan Patent Office on September 12, 2011, the entire content of which is hereby incorporated by reference.

It should be understood by those skilled in the art that various modifications, combinations, sub-combinations and alterations may occur depending on design requirements and other factors insofar as they are within the scope of the appended claims or the equivalents thereof.

## Claims

1. A thin-film transistor, comprising:
a gate electrode;
a semiconductor layer separated from the gate electrode with a separation insulating layer in between; and
a source electrode and a drain electrode that are connected with the semiconductor layer and are separated from each other,
wherein, between the source electrode and the drain electrode, a thickness of the separation insulating layer at a first region where the gate electrode does not overlap both the source electrode and the drain electrode is smaller than a thickness of the separation insulating layer at a second region where the gate electrode overlaps one or both of the source electrode and the drain electrode.

2. The thin-film transistor according to claim 1, wherein the semiconductor layer is an organic semiconductor layer.

3. The thin-film transistor according to claim 1 or 2, wherein the separation insulating layer includes a gate insulating layer, and the gate insulating layer contains an organic insulating material.

4. The thin-film transistor according to claim 1, 2 or 3, wherein a thickness of the separation insulating layer at the first region is smaller than a thickness of the separation insulating layer at the second region where the gate electrode and the source electrode overlap each other, and is smaller than a thickness of the separation insulating layer at the second region where the gate electrode and the drain electrode overlap each other.

5. The thin-film transistor according to any preceding claim, further comprising:
a stepped insulating layer provided at the first region; and
a gate insulating layer provided between the gate electrode and all of the semiconductor layer, the source electrode, and the drain electrode,
wherein the gate electrode is located between the stepped insulating layer and the gate insulating layer at the first region, and
the separation insulating layer is the gate insulating layer, and a thickness of the separation insulating layer is expressed by a thickness of the gate insulating layer.

6. The thin-film transistor according to claim 5, wherein the gate electrode is formed to cover the stepped insulating layer provided at the first region and the second region,
the gate insulating layer is formed on the gate electrode,
the semiconductor layer is formed on the gate insulating layer, and
the source electrode and the drain electrode are formed on the semiconductor layer.

7. The thin-film transistor according to claim 5, 6 or 7, wherein the gate electrode is formed to cover the stepped insulating layer provided at the first region, and the second region,
the gate insulating layer is formed on the gate electrode,
the source electrode and the drain electrode are formed on the gate insulating layer, and
the semiconductor layer is formed on the gate insulating layer, the source electrode, and the drain electrode.

8. The thin-film transistor according to any preceding claim, further comprising:
a stepped insulating layer provided at the second region; and
a gate insulating layer provided between all of the semiconductor layer, the source electrode and the drain electrode, and the stepped insulating layer,
wherein the stepped insulating layer is located between the gate insulating layer and the gate electrode at the second region, and
the separation insulating layer is the gate insulating layer and the stepped insulating layer, and a thickness of the separation insulating layer is expressed by a sum of a thickness of the gate insulating layer and a thickness of the stepped insulating layer.

9. The thin-film transistor according to claim 8, wherein the source electrode and the drain electrode are formed on the semiconductor layer,
the gate insulating layer is formed on the semiconductor layer, the source electrode, and the drain electrode,
the stepped insulating layer is formed on the gate insulating layer at the second region, and
the gate electrode is formed to cover the gate insulating layer and the stepped insulating layer provided at the second region.

10. The thin-film transistor according to claim 8 or 9, wherein the semiconductor layer is formed to cover the first region and the source electrode and the drain electrode provided at the second region,
the gate insulating layer is formed on the semiconductor layer,
the stepped insulating layer is formed on the gate insulating layer at the second region, and
the gate electrode is formed to cover the gate insulating layer and the stepped insulating layer provided at the second region.

11. The thin-film transistor according to any preceding claim, wherein a thickness of the gate electrode at the first region is greater than a thickness of the gate electrode at the second region.

12. The thin-film transistor according to claim 11, further comprising:
a gate insulating layer provided between the gate electrode and the semiconductor layer,
wherein the separation insulating layer is the gate insulating layer, and a thickness of the separation insulating layer is expressed by a thickness of the gate insulating layer.

13. The thin-film transistor according to claim 12, wherein the gate insulating layer is formed to cover the gate electrode provided at the first region and the second region,
the semiconductor layer is formed on the gate insulating layer, and
the source electrode and the drain electrode are formed on the semiconductor layer.

14. The thin-film transistor according to any preceding claim, wherein one or both of the source electrode and the drain electrode includes a comb-shaped portion having a plurality of divergent branch portions,
the source electrode and the drain electrode are disposed to engage with each other at the comb-shaped portion, and
the gate electrode is provided as a solid film in at least a region where the source electrode and the drain electrode engage with each other.

15. An electronic unit with a thin-film transistor, the thin-film transistor comprising:
a gate electrode;
a semiconductor layer separated from the gate electrode with a separation insulating layer in between; and
a source electrode and a drain electrode that are connected with the semiconductor layer and are separated from one another,
wherein, between the source electrode and the drain electrode, a thickness of the separation insulating layer at a first region where the gate electrode does not overlap both the source electrode and the drain electrode is smaller than a thickness of the separation insulating layer at a second region where the gate electrode overlaps one or both of the source electrode and the drain electrode.
